# EUROPEAN PATENT SPECIFICATION

(11) **EP 2 768 029 B1**
(45) Date of publication and mention of the grant of the patent: **19.10.2016**
(21) Application number: 13757910.8
(22) Date of filing: 05.03.2013
(51) Int. Cl.: H01L 31/0352, H01L 31/075

(54) **MULTI-QUANTUM WELL SOLAR CELL AND METHOD OF MANUFACTURING MULTI-QUANTUM WELL SOLAR CELL**
SOLARZELLE MIT MEHREREN QUANTENTÖPFEN UND HERSTELLUNGSVERFAHREN FÜR DIE SOLARZELLE MIT MEHREREN QUANTENTÖPFEN
CELLULE SOLAIRE MULTI-PUITS QUANTIQUE ET PROCÉDÉ DE FABRICATION DE CELLULE SOLAIRE MULTI-PUITS QUANTIQUE

(30) Priority: 06.03.2012 JP 2012049805
(43) Date of publication of application: 20.08.2014
(73) Proprietor: Japan Science and Technology Agency, Kawaguchi-shi, Saitama 332-0012 (JP)
(72) Inventor: ITAGAKI Naho, Fukuoka-shi Fukuoka 819-0395 (JP); SHIRATANI Masaharu, Fukuoka-shi Fukuoka 819-0395 (JP); UCHIDA Giichiro, Fukuoka-shi Fukuoka 819-0395 (JP)
(74) Representative: Cabinet Plasseraud
(86) International application number: PCT/JP2013/055973
(87) International publication number: WO 2013/133264

(56) References cited:
- JP-A- 2008 277 865
- JP-A- 2010 186 915
- JP-A- 2011 187 591
- JP-A- 2011 238 661
- US-A1- 2008 156 366
- NEUFELD CARL ET AL: "Effect of doping and polarization on carrier collection in InGaN quantum well solar cells", APPLIED PHYSICS LETTERS, AMERICAN INSTITUTE OF PHYSICS, US, vol. 98, no. 24, 16 June 2011 (2011-06-16) , pages 243507-243507, XP012141110, ISSN: 0003-6951, DOI: 10.1063/1.3595487
- ASGHAR ASGARI ET AL: "Temperature dependence of InGaN/GaN multiple quantum well based high efficiency solar cell", SOLAR ENERGY MATERIALS AND SOLAR CELLS, ELSEVIER SCIENCE PUBLISHERS, AMSTERDAM, NL, vol. 95, no. 11, 2 July 2011 (2011-07-02), pages 3124-3129, XP028257503, ISSN: 0927-0248, DOI: 10.1016/J.SOLMAT.2011.07.001 [retrieved on 2011-07-12]
- KANDASWAMY P ET AL: "GaN/AlN short-period superlattices for intersubband optoelectronics: A systematic study of their epitaxial growth, design, and performance", JOURNAL OF APPLIED PHYSICS, AMERICAN INSTITUTE OF PHYSICS, US, vol. 104, no. 9, 4 November 2008 (2008-11-04), pages 93501-93501, XP012118029, ISSN: 0021-8979, DOI: 10.1063/1.3003507
- KOICHI MATSUSHIMA ET AL: "Fabrication of ZnInON/ZnO multi-quantum well solar cells", THIN SOLID FILMS, vol. 587, 17 January 2015 (2015-01-17), pages 106-111, XP055191307, ISSN: 0040-6090, DOI: 10.1016/j.tsf.2015.01.012

## Description

### {TECHNICAL FIELD}

The present invention relates to a solar cell, and in particular to a multi-quantum well solar cell, and to a method of manufacturing a multi-quantum well solar cell.

### {BACKGROUND ART}

Most solar cells currently employ Si as a material, but because only light of a wavelength range that corresponds to the particular forbidden bandgap of this material can be utilized, there are limits to the conversion efficiency achievable with a solar cell made of a single material. For this reason, in an attempt to increase photoelectric conversion efficiency, there has been proposed a tandem solar cell structure that employs a plurality of materials of different forbidden bandgaps. In this tandem solar cell structure, solar cells of materials having progressively wider forbidden bandgaps are layered in order from the light-receiving surface side, making it possible to utilize light of a wide wavelength range corresponding to the forbidden bandgaps of each of the solar cells.

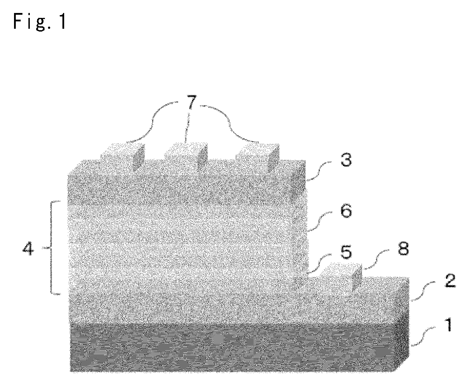

A solar cell structure that utilizes quantum wells has also been proposed as another technique for utilizing light of a wide wavelength range (see Non-patent Document 1). A solar cell having this structure is called a solar cell having a multi-quantum well structure (herein also referred to as a "multi-quantum well solar cell"), of which FIG. 1 is a simplified diagram showing one example. As shown in FIG. 1, the multi-quantum well solar cell has a structure in which an i-type semiconductor layer 4 is introduced as an intermediate layer into a semiconductor pn junction region between a p-type semiconductor layer 2 and an n-type semiconductor layer 3 furnished on a substrate 1, disposing electrodes 7 on the n-type semiconductor layer 3 and an electrode 8 on the p-type semiconductor layer 2. The i-type semiconductor layer 4 is formed from a barrier layer 5 which is formed of the semiconductor material that forms the p-type semiconductor layer 2 and the n-type semiconductor layer 3, and a well layer 6 formed of a semiconductor material that has a narrower forbidden bandgap than the aforementioned semiconductor material.

By adopting the aforedescribed multi-quantum well structure, it is possible to utilize, for the purposes of photoelectric conversion, not only light that corresponds to the forbidden bandgap of the semiconductor material that forms the pn junction, but also light that corresponds to the forbidden bandgap of the semiconductor material that forms the well layer, and to the subbands formed within the well layer, and to do so without lowering the open voltage. Consequently, sunlight further to the long wavelength end of contributes to the photoelectric effect as well, with the promise of affording a high-output solar cell having improved spectral sensitivity characteristics.

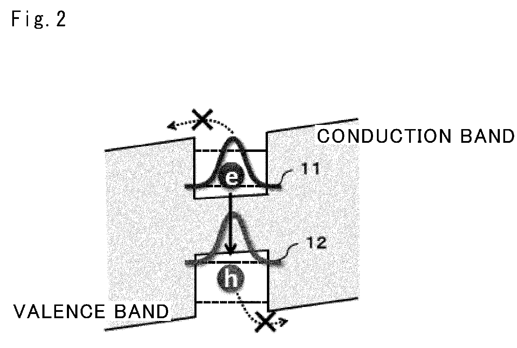

However, as shown in FIG. 2, a problem encountered with the aforedescribed multi-quantum well structure is that there is considerable overlap between the electron wave function 11 and the hole wave function 12 within the well layer, so that a majority of the carriers, i.e., electrons (e) and holes (h), generated through light absorption undergo recombination before escaping to outside the wells. For example, in the case of an InGaAs/GaAs quantum well having a barrier height of about 0.15 eV and well width of 2.5 nm, the average recombination lifetime is as short as 200 psec at a temperature of 125 K (see Non-patent document 2), and 70% or more of the carriers generated through light absorption recombine inside the well layer before escaping to the barrier layer. This high probability of recombination causes the efficiency of a multi-quantum well solar cell to decline greatly.

As for addressing the high probability of recombination in a multi-quantum well solar cell, there has been proposed a methodology of reducing the thickness of the barrier layer to 10 nm or less, and forming an intermediate band that combines between quantum wells (see Non-patent document 3). It is thought that, at this time, due to the tunneling effect, carriers generated within the quantum wells migrate at high speed within a miniband before recombination can occur, and that the output current is therefore greatly increased.

However, a problem encountered in actual practice when attempting to realize an intermediate-band solar cell is that the wave functions become localized for the following two reasons, lowering efficiency.
(1) Wave function localization due to non-uniformity of quantum well size: it is necessary for variability of quantum well size to be kept to within 10% in order to prevent wave function localization. In order to form an intermediate band, it is necessary for a quantum well to have a well width of 2-5 nm and a barrier layer width of 10 nm or less, but highly advanced manufacturing techniques are necessary in order to form these in highly uniform fashion.
(2) Wave function localization due to built-in field: in cases in which the built-in field of a solar cell is large despite formation of an intermediate layer, the resonant tunneling phenomenon between quantum wells breaks down due to electrostatic potential, resulting in localization of the wave function. Even if the number of quantum wells is increased, bringing the built-in voltage to about 10 kV/cm or lower, while the intermediate band is maintained, the increased probability of recombination associated with the increase in the number of quantum wells becomes a problem.

Moreover, as the materials constituting multi-quantum well solar cells, the principal constituent materials are III-V compound semiconductors. These involve fabrication by metal organic chemical vapor deposition (MOCVD) or molecular beam epitaxy (MBE), and therefore high manufacturing costs are problem.

The inventors previously filed a patent application based on the novel discovery that an oxynitride semiconductor in which Zn is a principal element other than a III-V compound has high stability to the environment, as well as having light sensitivity in the visible light region (see Patent Document 1). {Prior Art Documents}

### {Patent Documents}

Patent Document 1: Japanese Laid-Open Patent Application 2009-275236
Patent Document 2: Japanese Laid-Open Patent Application 2010-186915 A

### {Non-patent Documents}

Non-patent Document 1: Journal of Applied Physics, Vol. 67, p. 3490, 1990
Non-patent Document 2: P. Michler et al., Phys. Rev. B, 46, 7280, 1992
Non-patent Document 3: A. Luque and A. Marti, Phys. Rev. Lett., 78, 5014, 1997
Non-patent Document 4: Neufeld et al., « Effect of doping and polarization on carrier collection in InGaN quantum well solar cells, » Applied Physics Letters, American Institute of Physics, vol. 98, no. 24, 16 June 2011, pages 243507-243507, investigates the effect of doping and polarization on carrier collection for InGaN quantum well solar cells.

### {SUMMARY OF INVENTION}

### {Problems To Be Solved By The Invention}

However, even when the aforedescribed oxynitride semiconductor was applied to a multi-quantum well solar cell, the problem whereby a majority of carriers generated through photoreception of sunlight recombine before escaping to outside the quantum wells, [reducing] the photoelectric conversion efficiency, could not be solved.

As a result of painstaking research, the inventors made the novel discovery that when the metal oxynitride constituting the barrier layer and the well layer in a multi-quantum well solar cell is one composed of crystals having a wurtzite crystal structure, and additionally a piezoelectric field is generated in the well layer, the carriers (electrons, holes) generated by light absorption within the quantum wells can escape from the well layer into the barrier layer before recombining, thus prolonging the lifetime of the carriers within the quantum well layer; and that these carriers of prolonged lifetime contribute to electricity generation, whereby a multi-quantum well solar cell having high photoelectric conversion efficiency can be fabricated.

Specifically, an object of the present invention is to provide a low-cost multi-quantum well solar cell having high photoelectric conversion efficiency through reduced recombination of carriers generated by light absorption in the multi-quantum well solar cell, as well as a method of manufacturing the multi-quantum well solar cell.

### {Means for Solving the Problem}

The present invention resides in the following multi-quantum well solar cell and method of manufacturing a multi-quantum well solar cell.

(1) A multi-quantum well solar cell having a substrate, a p-type semiconductor layer, a barrier layer, a well layer, an n-type semiconductor layer, and electrodes, the multi-quantum well solar cell characterized in that
   the barrier layer and the well layer comprise crystals having a wurtzite crystal structure, the well layer being composed of a metal oxynitride containing the element Zn and at least one element selected from In, Ga, and Al; and
   a piezoelectric field is generated in the well layer.
(2) The multi-quantum well solar cell according to (1), characterized in that the piezoelectric field is 1 MV/cm or greater.
(3) The multi-quantum well solar cell according to (1) or (2), characterized in that the well layer is a layer formed by coherent growth.
(4) The multi-quantum well solar cell according to any of (1) to (3), characterized in that the lattice constant differential [(b - a)/a × 100] of the material forming the barrier layer (lattice constant a) and the material forming the well layer (lattice constant b) is from 0.5 to 20%.
(5) The multi-quantum well solar cell according to any of (1) to (4), characterized in that the barrier layer and the well layer are formed as a plurality of alternating layers, each of the well layers being formed from a material of a different bandgap.
(6) The multi-quantum well solar cell according to (5), characterized in that the well layers are formed of materials of progressively larger bandgap towards the side of incidence of sunlight.
(7) The multi-quantum well solar cell according to any of (1) to (6), characterized by having a ZnO buffer layer formed between the substrate and the p-type semiconductor layer by a nitrogen mediated crystallization process.
(8) The multi-quantum well solar cell according to any of (1) to (7), characterized in that the p-type semiconductor layer and the barrier layer are formed of the same material.
(9) The multi-quantum well solar cell according to (8), characterized in that the p-type semiconductor layer and the barrier layer are formed of ZnO.
(10) A method of manufacturing a multi-quantum well solar cell, including
   a step of layering on a substrate, in the stated order, a p-type semiconductor layer, a barrier layer, a well layer, a barrier layer, and an n-type semiconductor layer;
   a step of disposing an electrode on the p-type semiconductor layer; and
   a step of disposing an electrode on the n-type semiconductor layer;
   wherein the method of manufacturing a multi-quantum well solar cell is characterized in that the step of layering the barrier layer employs a material that yields a layer having a wurtzite crystal structure in the layer subsequent to layering; and
   the step of layering the well layer involves bringing about coherent growth of a material containing the element Zn and at least one element selected from In, Ga, and A, to a film thickness at which a piezoelectric field is generated, thereby yielding a strained layer having a wurtzite crystal structure.
(11) The method of manufacturing a multi-quantum well solar cell according to (10), characterized in that the step of layering the well layer on the barrier layer is carried out by sputtering.
(12) The method of manufacturing a multi-quantum well solar cell according to (10) or (11), characterized in that the steps of layering the barrier layer and the well layer are carried out employing materials for which the lattice constant differential [(b - a)/a × 100] of the material forming the barrier layer (lattice constant a) and the material forming the well layer (lattice constant b) is from 0.5 to 20%.
(13) The method of manufacturing a multi-quantum well solar cell according to any of (10) to (12), characterized in that the steps of layering the barrier layer and the well layer are carried out a plurality of times in alternating fashion, each step of layering the well layer being carried out while employing a material of a different bandgap.
(14) The method of manufacturing a multi-quantum well solar cell according to (13), characterized in that the steps of layering the well layer are carried out while employing materials of progressively larger bandgap towards the side on which sunlight is incident.
(15) The method of manufacturing a multi-quantum well solar cell according to any of (10) to (14), characterized by further having, before the step of layering the p-type semiconductor layer on the substrate, a step of forming a ZnO buffer layer by employing nitrogen mediated crystallization.
(16) The method of manufacturing a multi-quantum well solar cell according to any of (10) to (15), characterized in that the p-type semiconductor layer and the barrier layer are formed of the same material.
(17) The method of manufacturing a multi-quantum well solar cell according to (16), characterized in that the p-type semiconductor layer and the barrier layer are formed of ZnO.

According to the present invention, a piezoelectric field is generated in the well layer of the i-type semiconductor layer of a solar cell having a pin structure, thereby prolonging the lifetime of carriers within the quantum well layer, whereupon the carriers contribute electricity generation rather than recombining, whereby a multi-quantum well solar cell having high photoelectrical conversion efficiency can be provided.

Moreover, there can be provided a multi-quantum well solar cell that utilizes, for the purposes of photoelectric conversion, not only wavelengths corresponding to the forbidden bandgap of the semiconductor that constitutes the pin junction, but also light corresponding to the forbidden bandgap of the well layer and to subbands formed within the well layer.

According to the present invention, by employing a material containing the element Zn and at least one element selected from In, Ga, and Al to form the quantum well structure, a larger piezoelectric field can be generated as compared with conventional materials, layers can be formed by sputtering with excellent productivity, and a multi-quantum well solar cell can be provided at low cost.

Furthermore, by employing the same material for the p-type semiconductor layer and the barrier layer, the crystallinity of the film that forms the barrier layer can be improved, and the critical thickness increased, as a result of which the critical thickness for coherent growth of the well layer can be increased, and the recombination rate can be greatly lowered. Additionally, by forming the p-type semiconductor layer and the barrier layer from ZnO, both the p-type semiconductor layer and the barrier layer can be formed by sputtering, and therefore process costs can be reduced.

### {BRIEF DESCRIPTION OF DRAWINGS}

FIG. 1 is a diagram showing a simplification of a conventional multi-quantum well solar cell;
FIG. 2 is a diagram showing a simplification of recombination of carriers within a quantum well of a conventional multi-quantum well solar cell;
FIG. 3 is a diagram showing a simplification of the multi-quantum well solar cell of the present invention;
FIG. 4 is a diagram showing a simplification of recombination of carriers within a quantum well of the multi-quantum well solar cell of the present invention;
FIG. 5 is a diagram showing the procedure of a nitrogen mediated crystallization process;
FIG. 6 is a graph showing recombination rates within a quantum well; and
FIG. 7 is a drawing showing a reciprocal lattice map of the X-ray diffraction (105) plane of a ZnInON film constituting the well layer of the multi-quantum well solar cell of the present invention.

### {DESCRIPTION OF EMBODIMENTS}

The present invention features a multi-quantum well solar cell wherein the metal oxynitride constituting the quantum wells is composed of crystals having a wurtzite crystal structure, and additionally a piezoelectric field is generated in the well layer, whereby carriers (electrons, holes) generated by light absorption within the quantum wells may escape from the well layer into the barrier layer before recombining, thus prolonging the lifetime of the carriers within the quantum well layer, the carriers contributing to electricity generation, whereby high photoelectric conversion efficiency can be attained. The multi-quantum well solar cell and the method of manufacturing a multi-quantum well solar cell of the present invention are described in more specific terms below.

In the present invention, a "quantum well structure" means a structure that includes a barrier layer and a well layer; a "quantum well" means the well portion of a potential well; and a "well layer" means the layer that constitutes the well portion in a potential well.

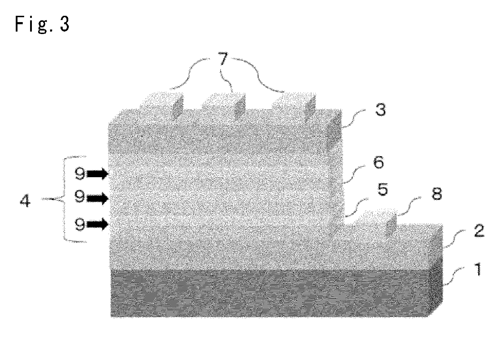

FIG. 3 shows an example of the multi-quantum well solar cell of the present invention, having a structure provided with a substrate 1, a p-type semiconductor layer 2 disposed on the substrate 1, an n-type semiconductor layer 3, an i-type semiconductor layer 4 introduced as an intermediate layer into the semiconductor pn junction region between the p-type semiconductor layer 2 and the n-type semiconductor layer 3, electrodes 7 disposed on the n-type semiconductor layer 3, and an electrode 8 disposed on the p-type semiconductor layer 2. The i-type semiconductor layer 4 is formed from a barrier layer 5 formed of the semiconductor material that forms the p-type semiconductor layer 2 and the n-type semiconductor layer 3, and a well layer 6 formed of a semiconductor material having a narrower forbidden bandgap than the aforementioned semiconductor material. A piezoelectric field is generated by creating strain 9 in the well layer 6.

As examples of the material of the substrate 1, there can be cited sapphire, which is typically employed in growing of wurtzite crystals, as well as GaN, ZnO, Si, SiC, ScAlMgO₄ (SCAM), Y-stabilized ZrO₂ (YSZ), and the like.

As examples of the material of the p-type semiconductor layer 2, there can be cited GaN, ZnInON, Si, ZnO, SiC, AlN, InN, and mixed crystals thereof. Optionally, dopants such as magnesium, nitrogen, antimony, phosphorus, boron, and the like can be added, as appropriate, depending on the material employed.

As examples of the material of the n-type semiconductor layer 3, there can be cited GaN, ZnInON, Si, ZnO, SiC, AlN, InN, and mixed crystals thereof. Optionally, dopants such as aluminum, gallium, boron, silicon, phosphorus, and the like can be added, as appropriate, depending on the material employed.

As examples of the material of the barrier layer 5, there can be cited GaN, ZnInON, ZnO, SiC, AlN, InN, and mixed crystals thereof.

There are no particular limitations as to the electrodes 7 disposed on the n-type semiconductor layer 3, and any of those employed in the field are acceptable; for example, there can be cited aluminum, aluminum-doped zinc oxide, gallium-doped zinc oxide, titanium/gold, and the like. Likewise, there are no particular limitations as to the electrode 8 disposed on the p-type semiconductor layer 2, and any of those employed in the field are acceptable; for example, there can be cited Au-nickel, platina, ITO, silver, and the like.

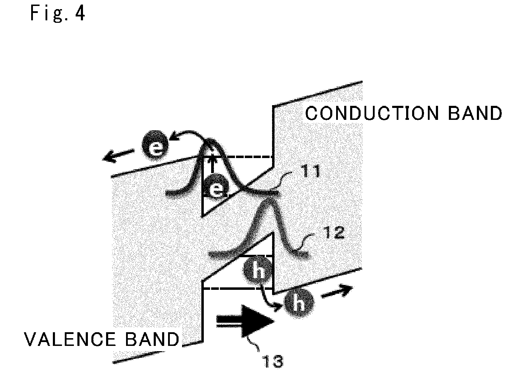

It is crucial that a piezoelectric field is generated in the well layer 6 by creating strain 9 as described above. As shown in FIG. 4, by creating strain 9 in the well layer 6, electrons (e) and holes (h) generated through light absorption migrate in spatially divergent directions due to the piezoelectric field 13, thereby giving rise to discrepancy between the electron wave function 11 and the hole wave function 12, making it difficult for the electrons (e) and the holes (h) to recombine, and improving the photoelectric conversion efficiency as a result.

In order to generate the piezoelectric field, it is necessary that the well layer 6: (1) be a film formed of a material that yields a wurtzite crystal structure, (2) be imparted with strain, and (3) has a film thickness sufficient to generate a piezoelectric field.

There are no limitations as to the material that yields a wurtzite crystal structure as long as the material is one that yields a wurtzite crystal structure; from the standpoint of keeping manufacturing cost low, and obtaining a wide range of bandgaps, a material containing Zn and at least one element selected from In, Ga, and Al is preferred. ZnInON, ZnGaON, ZnAlON, InGaZnON, and the like may cited.

The bandgap can be adjusted by varying the composition of the aforedescribed materials. For example, in the case of indium zinc oxynitride (ZnInON), the bandgap becomes smaller as the proportion of In and nitrogen is increased, whereas the bandgap becomes larger as the proportion of oxygen and Zn is increased. In specific terms, it is possible to modulate the bandgap within a wide range of about 1.3 to 3.0 eV. Consequently, in cases in which the aforedescribed material is employed in the multi-quantum well solar cell of the present invention, the bandgap of the well layer 6 and of the barrier layer 5 can be controlled to absorb light of a wide range of wavelengths. In a case in which the bandgap of the well layer 6 differs between each of the well layers 6, in order for incident sunlight to reach down to the lower well layer 6, it is preferable for layers closer to the surface at which sunlight is incident to be formed of materials of larger bandgaps. In a well layer 6 having a large bandgap, only that light which, of the incident sunlight, has a large bandgap undergoes photoelectric conversion, while in the next well layer 6, light having the next largest bandgap undergoes photoelectric conversion, so that the incident light undergoes successive photoelectric conversion starting with light of the largest bandgap, and is efficiently utilized down the well layer 6 of the lower layer. Moreover, a thinner film is possible due to having a large light-absorption coefficient (10⁴⁻⁵ cm⁻¹) afforded by the direct transition bandgap, and lower cost is possible.

The piezoelectric field is generated through piezoelectric polarization arising from strain 9 of the crystal structure. Impartation of strain 9 to the well layer 6 can be accomplished through coherent growth, employing a material of a lattice constant that is greater than the lattice constant of the barrier layer 5. Coherent growth refers to a condition in which, due to a slight differential between the lattice constants of materials forming a first layer and a second layer, the atomic arrangement of the semiconductor expands and contracts, so that crystal growth occurs without crystal defects arising; in other words, a condition in which there is no discontinuity of crystal planes at the interface of the first layer and the second layer, or in which lattice relaxation between the two is completely nonexistent, or the lattice relaxation is negligible.

Coherent growth refers to a condition of growth in the aforedescribed manner, and provided that such crystal growth takes place, may be brought about using known methods to supply the materials for forming the layers, such as sputtering, pulsed laser deposition, MOCVD, MBE, HVPE, electron beam deposition vapor phase process, or some combination of these. For example, with ordinary sputtering, crystal growth takes place at the lattice constant possessed by the material, but when coherent growth of the well layer 6 is brought about on the barrier layer 5 while employing a material of a larger lattice constant than the barrier layer 5, the well layer 6 grows at the lattice constant of the material of the barrier layer, or at a slightly relaxed value, as a result of which the well layer 6 grows under conditions such that compressive strain is incorporated in in-plane directions. In preferred practice, the lattice constant differential [(b - a)/a x 100] of the material forming the barrier layer 5 (lattice constant a) and the material forming the well layer 6 (lattice constant b) is on the order of from 0.5 to 20%, preferably 1 to 10%. Coherent growth does not occur at above 20%, whereas at less than 0.5%, the piezoelectric field is 1 MV or less, the recombination-inhibiting effect is minimal, and photoelectric conversion is poor.

The critical thickness of the well layer 6 for generating the piezoelectric field is dependent upon the lattice constant differential between the barrier layer 5 and the well layer 6. For example, in the case of a 20% lattice constant differential, the thickness of the well layer 6 may be about 5 nm or less; in the case of 10%, about 30 nm or less, and in the case of 0.5%, 100 nm or less. The strength of the piezoelectric field is greater at larger lattice constant differentials between the barrier layer 5 and the well layer 6, whereas on the other hand, as the lattice constant differential becomes larger, the critical thickness becomes thinner, and sufficient light can no longer be absorbed. Therefore, in order to improve photoelectric conversion efficiency, the lattice constants and the critical thickness should be established appropriately within suitable ranges.

The lattice constant of the material for forming the well layers 6 of the present invention may be changed on the order of 10%, by varying the composition ratio of the material. Therefore, during layering of the barrier layer 5 and the well layers 6 in the c axis direction, by forming the quantum wells while adjusting the composition ratio of the material forming each of the well layers 6, it is possible to adjust the strength of the piezoelectric field generated through strain of the crystal lattice, without varying the elements that constitute the material.

According to the present invention, by generating a piezoelectric field, the generated electrons (e) and holes (h) are induced to migrate in spatially divergent directions, thereby making it difficult for recombination to occur, whereby photoelectric conversion efficiency is improved as long as a piezoelectric field is generated, i.e., as long as the piezoelectric field is greater than zero, with the photoelectric conversion efficiency improving further the greater the piezoelectric field. Consequently, the piezoelectric field is preferably 1 MV/cm or above, more preferably 2 MV/cm or above, and especially preferably 3 MV/cm or above.

In preferred practice, the p-type semiconductor layer 2 and the barrier layer 5 of the present invention are formed of the same material. By forming the layers of the same material, the crystallinity of the film forming the barrier layer 5 is improved, and the critical thickness can be greater, as a result of which the critical thickness in coherent growth of the well layer 6 can be increased, and the recombination rate greatly lowered. The p-type semiconductor layer 2 and the barrier layer 5 are endowed with more desirable characteristics by being formed of the same material in the aforedescribed manner; with ZnO, because the layers can be formed by sputtering, from the standpoint of reducing process costs, the combination ZnO is especially preferable, from among the aforedescribed materials shown by way of example.

The quantum well structure of the present invention may be applied to the i-type semiconductor layer of a solar cell having the aforedescribed pin structure, or applied to the p-type semiconductor layer or the n-type semiconductor layer of a solar cell having a pn structure.

Next, the method of manufacturing a multi-quantum well solar cell of the present invention will be described.

The multi-quantum well solar cell of the present invention is fabricated by layering the p-type semiconductor layer 2 on the substrate 1, then successively layering the barrier layer 5, the well layer 6, and the barrier layer 5, then finally layering the n-type semiconductor layer 3, and disposing the electrodes 7 and the electrode 8. The electrode 8 may be disposed subsequent to layering of the p-type semiconductor layer 2. The barrier layer 5 and the well layer 6 may be layered in repeated fashion.

Layering of the p-type semiconductor layer 2 onto the substrate 1 may be accomplished by known methods such as sputtering, pulsed laser deposition, MOCVD, MBE, HVPE, electron beam deposition vapor phase process, or some combination of these. By employing nitrogen mediated crystallization to form on the substrate 1 a buffer layer of a ZnO film of excellent crystallinity prior to layering the p-type semiconductor layer 2 on the substrate 1, during subsequent layering the p-type semiconductor layer 2, the p-type semiconductor layer 2 of high quality can be formed by sputtering at low temperature and with excellent productivity.

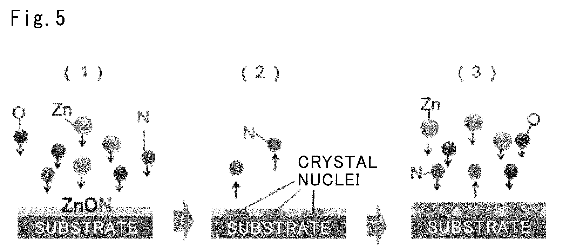

FIG. 5 shows the procedure of the nitrogen mediated crystallization process. Firstly, in Step (1), a ZnON film is formed while controlling generation of crystal nuclei through the addition of N as an impurity to the Zn and O sources for the film. In the case of formation of a ZnON film by sputtering, argon gas and nitrogen gas are introduced into the sputtering chamber while adjusting the gas flow rate. The mixture ratio of argon gas to nitrogen gas can be, for example, [N₂]/(Ar) + [N₂]) = 0.01 to 0.8. Through the introduction of nitrogen into the sputtering chamber, nitrogen molecules dissociate inside the chamber, giving rise to nitrogen atoms, and a ZnON film is formed on the substrate. Here, if the pressure inside the sputtering chamber is too high, the nitrogen molecules introduced into the sputtering chamber may fail to dissociate so that nitrogen atoms fail to be generated, resulting in undesirable formation of numerous crystal nuclei of ZnO. In order to avoid formation of large numbers of crystal nuclei and to form a ZnON film of adequate ZnO crystal nuclei density during this stage, the pressure inside the device is preferably 0.3 to 2.7 Pa, more preferably 0.3 Pa to 1.33 Pa, and especially preferably 0.3 Pa to 0.6 Pa.

Next, in Step (2), crystal nuclei are formed through adsorption of N by adjusting the temperature from room temperature to 800°C. Steps (1) and (2) may be carried out simultaneously.

Then, in Step (3), the materials Zn and O are supplied to grow ZnO crystals and form a buffer layer of a ZnO film. In Step (3), N may be supplied as well. At this time, N atoms adsorbed onto the film growth surface have the effect of promoting migration of the source elements Zn and O.

After the p-type semiconductor layer 2 has been layered, the barrier layer 5 is layered by sputtering, pulsed laser deposition, MOCVD, MBE, HVPE, electron beam deposition vapor phase process, or some combination of these.

As mentioned above, coherent growth is crucial when forming the well layer 6 on the barrier layer 5. Coherent growth requires the film thickness of the well layer 6 to be equal to or less than the aforedescribed critical thickness. The film thickness can be adjusted through control of the growing time.

The substrate temperature during formation of the well layer 6 can be set as appropriate. When sputtering has been employed, due to the high energy of the particles incident on the film growth surface, migration at the film growth surface is promoted, making it possible to form a metal oxynitride film of high quality even at low temperatures. The aforedescribed effect is particularly noticeable in cases in which the deposition rate is slow. In specific terms, by setting the deposition rate to 10 nm/min or less, metal oxynitride crystals of excellent crystallinity can be formed even at substrate temperatures of 300°C or less during formation of the well layer 6. Moreover, sputtering processes have cheaper device and running costs than other deposition procedures. By employing the material of the present invention in order to form the well layer 6, the well layer 6 can be formed by sputtering, which has the advantage that the solar cell of the present invention can be provided at low cost. A source gas containing N atoms in a gas phase (e.g., N₂, NH₃, NO, etc.) is introduced during formation of the metal oxynitride, according to the desired nitrogen concentration in the film. In cases in which a high nitrogen concentration in the film is desired, bombardment with N radicals using a radical source or the like is effective as well.

Layering of the barrier layer 5 on the well layer 6 is carried out by a method similar to layering the barrier layer 5 on the p-type semiconductor layer 2. A quantum well structure can then be formed through coherent growth of the well layer 6 on the barrier layer 5 by the aforedescribed method, and repeating this procedure. During manufacture, the composition ratio of the materials forming the well layers 6, or the lattice constant differential [with respect to] the material forming the barrier layer 5, should be adjusted appropriately so as to obtain the desired piezoelectric field strength. At this time, the composition ratio of the materials forming the well layers may be modified for each individual layer. In this case, it is desirable to make adjustments such that the bandgap is progressively greater towards the side at which sunlight is incident. In so doing, light corresponding to the bandgap of each of the well layers 6 can be absorbed efficiently.

After repeated layering of the well layers 6 and the barrier layers 5 the desired number of times, the n-type semiconductor layer 3 is layered on the barrier layer 5 by sputtering. The multi-quantum well solar cell of the present invention is fabricated by subsequently disposing the electrode 7 and the electrode 8 by an electron beam deposition process or sputtering process. As mentioned above, the electrode 8 may be disposed after the p-type semiconductor layer 2 has been layered.

The present invention is described in more specific terms through the following examples, which examples are merely intended for description of the present invention, and are provided for reference purposes as to specific embodiments thereof. The descriptions herein of certain specific embodiments of the present invention by way of example should not be construed as limiting or restricting the scope of the invention disclosed herein.

### {Examples}

### {Example 1}

### {ZnInON multi-quantum well solar cell}

Using a nitrogen mediated crystallization process, a ZnO buffer film was formed on a sapphire substrate 1 450 µm thick. Sputtering was employed for film formation, introducing argon gas and nitrogen gas into the sputtering chamber while adjusting the gas flow rates to bring the pressure to 0.3 Pa. The flow rates of the argon gas and nitrogen gas were [N₂] = 2 sccm, [Ar] = 20 sccm. Through introduction of nitrogen into the sputtering chamber, the nitrogen molecules dissociated into nitrogen atoms inside the chamber, and a ZnON film was formed on the substrate. The substrate temperature was 700°C.

Next, GaN having a lattice constant of 0.319 nm was layered by MOCVD to form the p-type semiconductor layer 2. Magnesium was employed as the p-type dopant. With the substrate temperature at 1150°C, flows of trimethyl gallium (TMG) as a Ga source, ammonia as an N source, and cyclopentadienyl magnesium (Cp₂Mg) as a magnesium source were introduced to layer a 5 µm GaN layer. Film formation was followed by annealing at 800°C in a nitrogen atmosphere to

Next, ZnO having a lattice constant of 0.325 nm was layered by sputtering to form the barrier layer 5. The film thickness of the barrier layer 5 was 12 nm. Next, coherent growth of the well layer 6 to a film thickness of 3 nm on the barrier layer 5 was brought about with ZnInON (composition ratio (atomic ratio) Zn : In = O : N = 85 : 15, Zn + In : O + N = 1 : 1) having a lattice constant of 0.329 nm. This value of film thickness is sufficiently smaller than the critical thickness at which lattice relaxation arises. A 2-inch sinter having a ZnO composition and a 2-inch sinter having an In composition (each with purity of 99.9%) were employed as the sputtering target (material source). The distance between the target and the substrate was about 12 cm, and the substrate temperature during film formation was 300°C. The ZnInON film was formed in an atmosphere of mixed argon/nitrogen gas at 0.3 Pa, the flow rates of the argon gas and nitrogen gas being [N₂] = 3 sccm, [Ar] = 22 sccm.

Next, layering of the barrier layer 5 and the well layer 6 by the aforedescribed procedure was repeated until the number of barrier layers 5 reached 30.

Next, the n-type semiconductor layer 3 was formed by sputtering of ZnO onto the barrier layer 5. Aluminum was employed as the n-type dopant. A 2-inch sinter (purity of 99.9%) having a ZnO : Al₂O₃ (Al₂O₃ : 2 wt.%) composition was employed as the sputtering target (material source). The substrate temperature during film formation was 300°C. The ZnO film was formed in an atmosphere of argon gas at 0.3 Pa, the flow rate of the argon gas being [Ar] = 22.5 sccm.

Finally, ZnO : Al was layered by sputtering onto the n-type semiconductor layer 3 to form the electrode 7, and an Ni/Au layered film was layered by an electron beam deposition process onto the p-type semiconductor layer 2 to form the electrode 8, to fabricate a multi-quantum well solar cell. The barrier height of the quantum wells so fabricated was about 0.2 eV, the film thickness of the well layers was 3 nm, the film thickness of the barrier layers was 12 nm, and the piezoelectric field was 3.2 MV/cm.

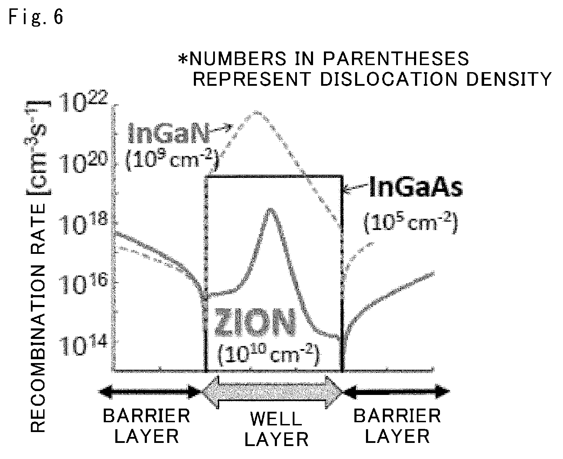

FIG. 6 shows the recombination rate inside a quantum well (ZION). As shown in FIG. 6, as compared with Comparative Example 2 (InGaAs) and Comparative Example 3 (InGaN) which will be discussed later, the recombination rate shows a lower value, as a result of which the photoelectric conversion efficiency was improved. At this time, the dislocation defect density in the ZnInON film of the well layer 6 showed a high value of 10¹⁰ cm⁻², but the recombination rate was successfully lowered considerably due to the strong piezoelectric field (3.2 MV/cm) within the well layers 6.

### {Comparative Example 1}

### {ZnInON multi-quantum well solar cell}

A multi-quantum well solar cell was fabricated in the same manner as in Example 1, except for employing as the material for the well layers 6 the ZnInON (composition ratio (atomic ratio) Zn : In = O : N = 65 : 35, Zn + In : O + N = 1 : 1) disclosed in Patent Document 1, and adopting a film thickness of 50 nm for the well layers 6, which is equal to or greater than the critical thickness for generating a piezoelectric field. Because no piezoelectric field was generated in the well layers 6, most of the optical generated carriers within the well layers 6 recombined.

### {Comparative Example 2}

### {InGaAs multi-quantum well solar cell}

A multi-quantum well solar cell was fabricated in the same manner as in Example 1, except for employing GaAs for the p-type semiconductor layer 2, GaAs for the barrier layers 5, InGaAs for the well layers 6, and GaAs for the n-type semiconductor layer 3, and employing an MBE process for fabrication, because the aforementioned GaAs and InGaAs cannot be layered by sputtering. When quantum wells having a barrier height of about 0.2 eV, well width of 3 nm, and barrier layer width of 12 nm, the recombination rate within the well layers 6 was as shown in FIG. 6. At this time, the dislocation defect density in the InGaAs film showed a low value of 10⁵ cm⁻², but there was considerable overlap of the electron-hole wave functions within the quantum well, and a high recombination rate was observed. In Comparative Example 2, due to the very low piezoelectric constant of the GaAs (001) plane, no piezoelectric field was generated despite that fact that strain was generated within the well layers 6 by the lattice constant differential.

### {Comparative Example 3}

### {InGaN multi-quantum well solar cell}

A multi-quantum well solar cell was fabricated in the same manner as in Example 1, except for employing GaN for the p-type semiconductor layer 2, GaN for the barrier layers 5, InGaN for the well layers 6, and GaN for the n-type semiconductor layer 3, and employing MOCVD for fabrication of the GaN and InGaN. In the GaN/InGaN quantum well structure of Comparative Example 3, a piezoelectric field (1.5 MV/cm) was generated due to a film thickness of the well layers 6 that was less than the critical thickness at which lattice relaxation arises. It was found that when quantum wells having barrier height of about 0.2 eV, well width of 3 nm, and barrier layer width of 12 nm were formed, as shown in FIG. 6, the recombination rate within the quantum wells was higher as compared with the quantum wells of Example 1. From this it was confirmed that through coherent growth using the material of the present invention as the material for the well layers 6, a higher piezoelectric field can be generated within the well layers 6 as compared with conventional materials, and that the recombination rate can be greatly reduced.

### {Example 2}

### {ZnInON multi-quantum well solar cell (p-type semiconductor layer and barrier layer: ZnO)}

A substrate on which was formed a ZnON film was formed by the same procedure as in Example 1. Next, ZnO having a lattice constant of 0.325 nm was layered by sputtering to form the p-type semiconductor layer 2. The substrate temperature during film formation was 700°C. The ZnO film was formed in an atmosphere of mixed argon/nitrogen/oxygen gas at 0.3 Pa, the flow rates of the argon gas, nitrogen gas, and oxygen gas being [Ar] = 45 sccm, [N₂] = 7 sccm, [O₂] = 2 sccm. Nitrogen was employed as the p-type dopant, and doping was carried out through radical formation in nitrogen gas.

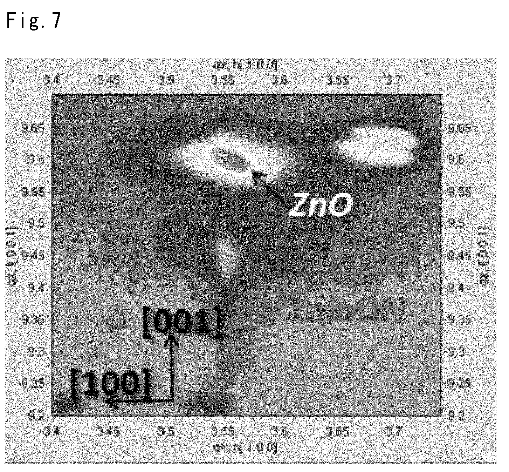

Next, the barrier layer 5 was formed by layering ZnO having a lattice constant of 0.325 nm using sputtering. The film thickness of the barrier layer 5 was 30 nm. Next, the well layer 6 was coherently grown on the barrier layer 5, to a film thickness of 30 nm with ZnInON (composition ratio (atomic ratio) Zn : In = O : N = 85 : 15, Zn + In : O + N = 1 : 1) having a lattice constant of 0.329 nm. It is thought that by employing the same material, i.e., ZnO, for the p-type semiconductor layer 2 as for the barrier layer 5, the crystallinity of the ZnO forming the barrier layer 5 was improved, and the critical thickness was greater. FIG. 7 shows the X-ray diffraction reciprocal lattice map in the (105) plane of a ZnInON film. The lattice constant in the (100) direction of the ZnInON film completely matched that of ZnO, and coherent growth was confirmed. The sputtering target (material source) and sputtering conditions were the same as in Example 1. Thereafter, layering of the barrier layer 5 and the well layer 6 by the same procedure as in Example 1 was repeated, and finally the electrodes were disposed, to fabricate the multi-quantum well solar cell of Example 2.

The fabricated quantum wells had a barrier height of about 0.2 eV, a quantum well layer film thickness of 30 nm, a barrier layer film thickness of 30 nm, and a piezoelectric field of 1 MV/cm. At this time, the maximum recombination rate in the well layer was 10¹⁷ cm⁻³s⁻¹, representing a one-order reduction as compared with Example 1. This is due to the increase in the film thickness of the well layer (3 nm → 30 nm), which lowered the value of the overlap integral of the wave functions.

From the aforedescribed results, it was found that by forming the p-type semiconductor layer 2 and the barrier layer 5 from the same material, the critical thickness in coherent growth of the well layers 6 could be increased, and the recombination rate greatly lowered. Moreover, because the ZnO film can be formed by sputtering, employing ZnO as the combination of materials for the p-type semiconductor layer 2 and the barrier layer 5 is advantageous from the standpoint of reduced process cost as well.

### {INDUSTRIAL APPLICABILITY}

With the multi-quantum well solar cell of the present invention, photoelectric conversion of light of a wide range of wavelengths can be accomplished highly efficiently, and with the manufacturing method of the present invention, multi-quantum well solar cells can be mass produced at low cost, which is useful in further disseminating the use of solar cells.

## Claims

1. A multi-quantum well solar cell having a substrate (1), a p-type semiconductor layer (2), a barrier layer (5), a well layer (6), an n-type semiconductor layer (3), and electrodes (7, 8), wherein
the barrier layer (5) and the well layer (6) comprise crystals having a wurtzite crystal structure, and
a piezoelectric field (13) is generated in the well layer (6), the multi-quantum well solar cell being **characterized in that** the well layer (6) is composed of a metal oxynitride containing the element Zn and at least one element selected from In, Ga, and Al.

2. The multi-quantum well solar cell according to claim 1, **characterized in that** the piezoelectric field (13) is 1 MV/cm or greater.

3. The multi-quantum well solar cell according to claim 1 or 2, **characterized in that** the well layer (6) is a layer formed by coherent growth.

4. The multi-quantum well solar cell according to any of claims 1 to 3, **characterized in that** the lattice constant differential [(b - a)/a × 100] of the material forming the barrier layer (5) (lattice constant a) and the material forming the well layer (6) (lattice constant b) is from 0.5 to 20%.

5. The multi-quantum well solar cell according to any of claims 1 to 4, **characterized in that** the barrier layer (5) and the well layer (6) are formed as a plurality of alternating layers, each of the well layers (6) being formed from a material of a different bandgap.

6. The multi-quantum well solar cell according to claim 5, **characterized in that** the well layers (6) are formed of materials of progressively larger bandgap towards the side of incidence of sunlight.

7. The multi-quantum well solar cell according to any of claims 1 to 6, **characterized by** having a ZnO buffer layer formed between the substrate (1) and the p-type semiconductor layer (2) by nitrogen mediated crystallization.

8. The multi-quantum well solar cell according to any of claims 1 to 7, **characterized in that** the p-type semiconductor layer (2) and the barrier layer (5) are formed of the same material.

9. The multi-quantum well solar cell according to claim 8, **characterized in that** the p-type semiconductor layer (2) and the barrier layer (5) are formed of ZnO.

10. A method of manufacturing a multi-quantum well solar cell, including
a step of layering on a substrate (1), in the stated order, a p-type semiconductor layer (2), a barrier layer (5), a well layer (6), and an n-type semiconductor layer (3);
a step of disposing an electrode (8) on the p-type semiconductor layer (2); and
a step of disposing an electrode (7) on the n-type semiconductor layer (3);
wherein the step of layering the barrier layer (5) employs a material that yields a layer having a wurtzite crystal structure in the layer subsequent to layering; and wherein the method of manufacturing a multi-quantum well solar cell is **characterized in that**
the step of layering the well layer (6) involves bringing about coherent growth of a metal oxynitride material containing the element Zn, and at least one element selected from In, Ga, and Al, to a film thickness at which a piezoelectric field (13) is generated, thereby yielding a strained layer having a wurtzite crystal structure.

11. The method of manufacturing a multi-quantum well solar cell according to claim 10, **characterized in that** the step of layering the well layer (6) on the barrier layer (5) is carried out by sputtering.

12. The method of manufacturing a multi-quantum well solar cell according to claim 10 or 11, **characterized in that** the steps of layering the barrier layer (5) and the well layer (6) are carried out employing materials for which the lattice constant differential [(b - a)/a × 100] of the material forming the barrier layer (5)(lattice constant a) and the material forming the well layer (6)(lattice constant b) is from 0.5 to 20%.

13. The method of manufacturing a multi-quantum well solar cell according to any of claims 10 to 12, **characterized in that** the steps of layering the barrier layer (5) and the well layer (6) are carried out a plurality of times in alternating fashion, each step of layering the well layer (6) being carried out while employing a material of a different bandgap.

14. The method of manufacturing a multi-quantum well solar cell according to claim 13, **characterized in that** the steps of layering the well layer (6) are carried out while employing materials of progressively larger bandgap towards the side on which sunlight is incident.

15. The method of manufacturing a multi-quantum well solar cell according to any of claims 10 to 14, **characterized by** further having, before the step of layering the p-type semiconductor layer (2) on the substrate (1), a step of forming a ZnO buffer layer by employing nitrogen mediated crystallization.

16. The method of manufacturing a multi-quantum well solar cell according to any of claims 10 to 15, **characterized in that** the p-type semiconductor layer (2) and the barrier layer (5) are formed of the same material.

17. The method of manufacturing a multi-quantum well solar cell according to claim 16, **characterized in that** the p-type semiconductor layer (2) and the barrier layer (5) are formed of ZnO.

## Patentansprüche

1. Mehrfach-Quantentopf-Solarzelle mit einem Substrat (1), einer Halbleiterschicht vom p-Typ (2), einer Sperrschicht (5), einer Topfschicht (6), einer Halbleiterschicht vom n-Typ (3) und Elektroden (7, 8), wobei die Sperrschicht (5) und die Topfschicht (6) Kristalle mit einer Wurtzit-Kristallstruktur umfassen und ein piezoelektrisches Feld (13) in der Topfschicht (6) erzeugt wird, wobei die Mehrfach-Quantentopf-Solarzelle **dadurch gekennzeichnet ist, dass** die Topfschicht (6) aus einem Metalloxidnitrid gebildet ist, das das Element Zn und mindestens ein Element, ausgewählt aus In, Ga und Al, enthält.

2. Mehrfach-Quantentopf-Solarzelle nach Anspruch 1, **dadurch gekennzeichnet, dass** das piezoelektrische Feld (13) 1 MV/cm oder darüber beträgt.

3. Mehrfach-Quantentopf-Solarzelle nach Anspruch 1 oder 2, **dadurch gekennzeichnet, dass** die Topfschicht (6) eine durch kohärentes Wachstum ausgebildete Schicht ist.

4. Mehrfach-Quantentopf-Solarzelle nach einem der Ansprüche 1 bis 3, **dadurch gekennzeichnet, dass** der Unterschied der Gitterkonstanten [(b - a)/a · 100] des die Sperrschicht (5) ausbildenden Materials (Gitterkonstante a) und des die Topfschicht (6) ausbildenden Materials (Gitterkonstante b) 0,5 bis 20 % beträgt.

5. Mehrfach-Quantentopf-Solarzelle nach einem der Ansprüche 1 bis 4, **dadurch gekennzeichnet, dass** die Sperrschicht (5) und die Topfschicht (6) als Mehrzahl von alternierenden Schichten ausgebildet sind, wobei jede der Topfschichten (6) aus einem Material mit einer anderen Bandlücke ausgebildet ist.

6. Mehrfach-Quantentopf-Solarzelle nach Anspruch 5, **dadurch gekennzeichnet, dass** die Topfschichten (6) aus Materialien mit einer zunehmend größeren Bandlücke in Richtung der Seite des Sonnenlichteinfalls ausgebildet sind.

7. Mehrfach-Quantentopf-Solarzelle nach einem der Ansprüche 1 bis 6, **dadurch gekennzeichnet, dass** sie eine ZnO-Pufferschicht aufweist, die zwischen dem Substrat (1) und der Halbleiterschicht vom p-Typ (2) durch stickstoffvermittelte Kristallisation ausgebildet ist.

8. Mehrfach-Quantentopf-Solarzelle nach einem der Ansprüche 1 bis 7, **dadurch gekennzeichnet, dass** die Halbleiterschicht vom p-Typ (2) und die Sperrschicht (5) aus demselben Material ausgebildet sind.

9. Mehrfach-Quantentopf-Solarzelle nach Anspruch 8, **dadurch gekennzeichnet, dass** die Halbleiterschicht vom p-Typ (2) und die Sperrschicht (5) aus ZnO ausgebildet sind.

10. Verfahren zur Herstellung einer Mehrfach-Quantentopf-Solarzelle, umfassend:
einen Schritt des Aufbringens auf ein Substrat (1) einer Halbleiterschicht vom p-Typ (2), einer Sperrschicht (5), einer Topfschicht (6) und einer Halbleiterschicht vom n-Typ (3) in der angegebenen Reihenfolge;
einen Schritt des Anordnens einer Elektrode (8) auf der Halbleiterschicht vom p-Typ (2); und
einen Schritt des Anordnens einer Elektrode (7) auf der Halbleiterschicht vom n-Typ (3);
wobei der Schritt des Aufbringens der Sperrschicht (5) ein Material verwendet, das im Anschluss an das Aufbringen eine Schicht mit einer Wurtzit-Kristallstruktur in der Schicht liefert; und wobei das Verfahren zur Herstellung einer Mehrfach-Quantentopf-Solarzelle **dadurch gekennzeichnet ist, dass** der Schritt des Aufbringens der Topfschicht (6) beinhaltet: das Bewirken eines kohärenten Wachstums eines Metalloxidnitridmaterials, das das Element Zn und mindestens ein Element, ausgewählt aus In, Ga und Al, enthält, bis zu einer Filmdicke, bei der ein piezoelektrisches Feld (13) erzeugt wird, wodurch eine gespannte Schicht mit einer Wurtzit-Kristallstruktur hervorgebracht wird.

11. Verfahren zur Herstellung einer Mehrfach-Quantentopf-Solarzelle nach Anspruch 10, **dadurch gekennzeichnet, dass** der Schritt des Aufbringens der Topfschicht (6) auf die Sperrschicht (5) durch Sputtern durchgeführt wird.

12. Verfahren zur Herstellung einer Mehrfach-Quantentopf-Solarzelle nach Anspruch 10 oder 11, **dadurch gekennzeichnet, dass** die Schritte des Aufbringens der Sperrschicht (5) und der Topfschicht (6) unter Verwendung von Materialien durchgeführt werden, für die der Unterschied der Gitterkonstanten [(b - a)/a · 100] des die Sperrschicht (5) ausbildenden Materials (Gitterkonstante a) und des die Topfschicht (6) ausbildenden Materials (Gitterkonstante b) 0,5 bis 20 % beträgt.

13. Verfahren zur Herstellung einer Mehrfach-Quantentopf-Solarzelle nach einem der Ansprüche 10 bis 12, **dadurch gekennzeichnet, dass** die Schritte des Aufbringens der Sperrschicht (5) und der Topfschicht (6) mehrmals abwechselnd durchgeführt werden, wobei jeder Schritt des Aufbringens der Topfschicht (6) unter Verwendung eines Materials mit einer anderen Bandlücke durchgeführt wird.

14. Verfahren zur Herstellung einer Mehrfach-Quantentopf-Solarzelle nach Anspruch 13, **dadurch gekennzeichnet, dass** die Schritte des Aufbringens der Topfschicht (6) unter Verwendung von Materialien mit einer zunehmend größeren Bandlücke in Richtung der Seite, auf die Sonnenlicht auftrifft, durchgeführt werden.

15. Verfahren zur Herstellung einer Mehrfach-Quantentopf-Solarzelle nach einem der Ansprüche 10 bis 14, **dadurch gekennzeichnet, dass** es vor dem Schritt des Aufbringens der Halbleiterschicht vom p-Typ (2) auf das Substrat (1), weiterhin einen Schritt des Ausbildens einer ZnO-Pufferschicht durch Anwendung von stickstoffvermittelter Kristallisation aufweist.

16. Verfahren zur Herstellung einer Mehrfach-Quantentopf-Solarzelle nach einem der Ansprüche 10 bis 15, **dadurch gekennzeichnet, dass** die Halbleiterschicht vom p-Typ (2) und die Sperrschicht (5) aus demselben Material ausgebildet werden.

17. Verfahren zur Herstellung einer Mehrfach-Quantentopf-Solarzelle nach Anspruch 16, **dadurch gekennzeichnet, dass** die Halbleiterschicht vom p-Typ (2) und die Sperrschicht (5) aus ZnO ausgebildet werden.

## Revendications

1. Cellule solaire à multi-puits quantiques comportant un substrat (1), une couche de semi-conducteur de type p (2), une couche de barrière (5), une couche de puits (6), une couche de semi-conducteur de type n (3), et des électrodes (7, 8), dans laquelle la couche de barrière (5) et la couche de puits (6) comprennent des cristaux ayant une structure cristalline de type wurtzite, et un champ piézoélectrique (13) est généré dans la couche de puits (6), la cellule solaire à multi-puits quantiques étant **caractérisée en ce que** la couche de puits (6) est composée d'un oxynitrure métallique contenant l'élément Zn et au moins un élément choisi parmi In, Ga et Al.

2. Cellule solaire à multi-puits quantiques selon la revendication 1, **caractérisée en ce que** le champ piézoélectrique (13) est supérieur ou égal à 1 MV/cm.

3. Cellule solaire à multi-puits quantiques selon la revendication 1 ou 2, **caractérisée en ce que** la couche de puits (6) est une couche formée par croissance cohérente.

4. Cellule solaire à multi-puits quantiques selon l'une quelconque des revendications 1 à 3, **caractérisée en ce que** la différence entre les constantes de réseau [(b - a)/a x 100] du matériau formant la couche de barrière (5) (constante de réseau a) et du matériau formant la couche de puits (6) (constante de réseau b) est de 0,5 à 20 %.

5. Cellule solaire à multi-puits quantiques selon l'une quelconque des revendications 1 à 4, **caractérisée en ce que** la couche de barrière (5) et la couche de puits (6) sont formées sous la forme d'une pluralité de couches alternées, chacune des couches de puits (6) étant formée à partir d'un matériau ayant une bande interdite différente.

6. Cellule solaire à multi-puits quantiques selon la revendication 5, **caractérisée en ce que** les couches de puits (6) sont formées à partir de matériaux ayant une bande interdite augmentant progressivement vers le côté d'incidence de la lumière solaire.

7. Cellule solaire à multi-puits quantiques selon l'une quelconque des revendications 1 à 6, **caractérisée en ce qu'**elle comporte une couche tampon de ZnO formée entre le substrat (1) et la couche de semi-conducteur de type p (2) par cristallisation médiée par l'azote.

8. Cellule solaire à multi-puits quantiques selon l'une quelconque des revendications 1 à 7, **caractérisée en ce que** la couche de semi-conducteur de type p (2) et la couche de barrière (5) sont formées à partir du même matériau.

9. Cellule solaire à multi-puits quantiques selon la revendication 8, **caractérisée en ce que** la couche de semi-conducteur de type p (2) et la couche de barrière (5) sont formées de ZnO.

10. Procédé de fabrication d'une cellule solaire à multi-puits quantiques, comprenant une étape de stratification sur un substrat (1), dans l'ordre indiqué, d'une couche de semi-conducteur de type p (2), d'une couche de barrière (5), d'une couche de puits (6) et d'une couche de semi-conducteur de type n (3) ;
une étape de dépôt d'une électrode (8) sur la couche de semi-conducteur de type p (2) ; et
une étape de dépôt d'une électrode (7) sur la couche de semi-conducteur de type n (3) ;
dans lequel l'étape de stratification de la couche de barrière (5) fait appel à un matériau qui donne une couche ayant une structure cristalline de type wurtzite dans la couche à la suite de la stratification ; et dans lequel le procédé de fabrication d'une cellule solaire à multi-puits quantiques est **caractérisé en ce que** l'étape de stratification de la couche de puits (6) implique de provoquer la croissance à peu près cohérente d'un matériau d'oxynitrure métallique contenant l'élément Zn, et au moins un élément choisi parmi In, Ga et Al, jusqu'à une épaisseur de film à laquelle un champ piézoélectrique (13) est généré, pour ainsi obtenir une couche sollicitée ayant une structure cristalline de type wurtzite.

11. Procédé de fabrication d'une cellule solaire à multi-puits quantiques selon la revendication 10, **caractérisé en ce que** l'étape de stratification de la couche de puits (6) sur la couche de barrière (5) est réalisée par pulvérisation cathodique.

12. Procédé de fabrication d'une cellule solaire à multi-puits quantiques selon la revendication 10 ou 11, **caractérisé en ce que** les étapes de stratification de la couche de barrière (5) et de la couche de puits (6) sont réalisées en utilisant des matériaux pour lesquels la différence entre les constantes de réseau [(b - a)/a x 100] du matériau formant la couche de barrière (5) (constante de réseau a) et du matériau formant la couche de puits (6) (constante de réseau b) est de 0,5 à 20 %.

13. Procédé de fabrication d'une cellule solaire à multi-puits quantiques selon l'une quelconque des revendications 10 à 12, **caractérisé en ce que** les étapes de stratification de la couche de barrière (5) et de la couche de puits (6) sont réalisées une pluralité de fois de manière alternée, chaque étape de stratification de la couche de puits (6) étant réalisée tout en utilisant un matériau ayant une bande interdite différente.

14. Procédé de fabrication d'une cellule solaire à multi-puits quantiques selon la revendication 13, **caractérisé en ce que** les étapes de stratification de la couche de puits (6) sont réalisées tout en utilisant des matériaux ayant une bande interdite augmentant progressivement vers le côté où la lumière solaire est incidente.

15. Procédé de fabrication d'une cellule solaire à multi-puits quantiques selon l'une quelconque des revendications 10 à 14, **caractérisé en ce qu'**il comprend en outre, avant l'étape de stratification de la couche de semi-conducteur de type p (2) sur le substrat (1), une étape de formation d'une couche tampon de ZnO par cristallisation médiée par l'azote.

16. Procédé de fabrication d'une cellule solaire à multi-puits quantiques selon l'une quelconque des revendications 10 à 15, **caractérisé en ce que** la couche de semiconducteurs de type p (2) et la couche de barrière (5) sont formées à partir du même matériau.

17. Procédé de fabrication d'une cellule solaire à multi-puits quantiques selon la revendication 16, **caractérisé en ce que** la couche de semi-conducteur de type p (2) et la couche de barrière (5) sont formées de ZnO.
